# EUROPEAN PATENT SPECIFICATION

(11) **EP 0 366 744 B1**
(45) Date of publication and mention of the grant of the patent: **13.01.1993**
(21) Application number: 89904382.2
(22) Date of filing: 31.03.1989
(51) Int. Cl.: H05K 7/10

(54) **IMPROVED RETENTION MEANS FOR CHIP CARRIER SOCKETS**
HALTEMITTEL FÜR IC-TRÄGERFASSUNGEN
MOYEN DE RETENTION AMELIORE POUR SUPPORTS INTERMEDIAIRES DE PUCES

(30) Priority: 06.05.1988 US 191635
(43) Date of publication of application: 09.05.1990
(73) Proprietor: THE WHITAKER CORPORATION, Wilmington, Delaware 19808 (US)
(72) Inventor: KORSUNSKY, Iosif, Harrisburg, PA 17110 (US); WALKER, Kevin, Eugene, Harrisburg, PA 17110 (US); BROWN, Robert, Wiliam, Harrisburg, PA 17109 (US)
(74) Representative: Klunker . Schmitt-Nilson . Hirsch
(86) International application number: US8901315
(87) International publication number: WO8911210

(56) References cited:
- EP-A- 163 414
- US-A- 4 349 238
- US-A- 4 547 031
- US-A- 4 623 208

## Description

The invention is directed to an improved retention means for use with a chip carrier socket and the like. The retention means insures that a chip carrier will be maintained in the chip carrier socket and that the chip carrier socket will be maintained in a closed position.

Integrated circuits are commonly mounted in chip carriers which are bodies of insulating material having side surfaces to which conductors from the integrated circuit extend. Traditionally, terminal pads are provided on the side surfaces of the chip carrier body and contact is made with these pads to connect the integrated circuit to conductors on a substrate, such as a ceramic substrate or a circuit board. Electrical connection is usually established with the terminal pads on the chip carrier by means of a chip carrier socket which comprises a socket body having a recess which receives the chip carrier and contact terminals in surrounding relationship to the recess so that when the chip carrier is placed in the recess, the contact terminals electrically engage the terminal pads of the chip carrier.

Notwithstanding the relatively small size of the chip carrier socket and the contact terminals in the socket, it is necessary that each terminal be capable of exerting contact force on a terminal pad in a chip carrier in the range of about 200 to 400 grams in order to establish good electrical connection between the contact terminal and the terminal pad on the chip carrier, particularly if the terminal pad is tin plated rather than gold plated. It should also be noted that chip carriers and chip carrier sockets are subject to the dimensional variations which all mass produced parts are subjected to. These dimensional variation result from manufacturing tolerances. However, even with dimensional variations, the design and performance requirements discussed briefly above must be satisfied even in "worst case" conditions. For example, the minimum 200 gram contact force required for each contact must be met even if the particular terminal pad that a contact terminal engages is at the lower end of the tolerance range and the contact terminal similarly is at the lower end of the tolerance range for the parts.

For the new emerging family of modified gull wing chip carriers, a new socket is required than is found in the prior art. The contact force, etc. discussed above must remain the same in order to insure that a proper electrical connection is maintained.

It is therefore essential that a chip carrier socket be provided with the capability to insure that the appropriate force be exerted on the contact terminals. It is also extremely important that the contact force required for proper operation be provided in such a manner as to not require special tools for operation. The present invention is specifically directed to the achievement of an improved retention means which is capable of providing a reliable electrical connection between the contact terminals and the contact pads.

For the new emerging family of modified gull wing chip carrier, a new chip carrier socket is required. Particularly, for the chip carriers that have large variations of the critical dimensions, which causes the leads of the chip carrier to not be uniformly positioned It is therefore necessary to have a chip carrier socket with improved retention means to insure that a reliable electrical connection is effected.

The invention is directed to a chip carrier socket having terminals provided therein and a first and second major surfaces of for socket body. The chip carrier socket provides the electrical connection required between a chip carrier housed in a protective handler and a printed circuit board.

Such a socket is known for example from US-A-4 547 031.

The chip carrier socket as claimed is characterized in that portions of the first major surface of the housing of the chip carrier socket are resilient retention areas. Respective sides of the resilient retention areas are integral with the first major surface, while the remaining sides of the resilient retention areas are spaced from the first major surface.

The portions of the resilient retention areas are movable from a first position, in which the portions are coplanar with the first major surface, to a second position, in which the portions are not coplanard with the first major surface. Resilient projections are integral with and extend from the resilient retention areas. The resilient projections extend beyond the second major surface. Whereby as the resilient projections have a force applied thereto, the resilient projections are moved, causing the resilient retention areas to move from the first position toward the second position, providing the strength required to prevent the failure of the resilient projections.

FIGURE 1 is an exploded perspective view of a chip carrier socket of the present invention.

FIGURE 2 is an enlarged perspective view of a terminal which is provided in the chip carrier socket.

FIGURE 3 is a partial cross sectional view of the chip carrier socket showing the terminals of the socket prior to the insertion of the cover-chip carrier subassembly therein.

FIGURE 4 is a partial cross sectional view similar to that of Figure 3, showing the chip carrier socket after the cover-chip carrier subassembly has been inserted therein.

FIGURE 5 is a cross section view of the chip carrier socket showing the latch means prior to the insertion of the cover-chip carrier subassembly therein.

FIGURE 6 is a view similar to that of Figure 5, showing the latch means as the subassembly is inserted onto the chip carrier socket.

FIGURE 7 is a view similar to that of Figure 5, showing the latch means after the subassembly is fully inserted onto the socket.

FIGURE 8 is a top plan view of a respective latch arm of the chip carrier socket.

FIGURE 9 is a top plan view of a respective securing arm of the cover.

The figures show a chip carrier socket 2 containing terminals 4 which engage contact leads 6 of a chip carrier 8 and which are soldered or otherwise connected to conductors on or in a substrate 10. An individual terminal 4 will first be described and structural details of the chip carrier socket 2 and a cover 12 used in cooperation therewith will then be described.

Each terminal 4 (Figure 2) is a complanate or flat member of the type commonly produced by etching or by stamping sheet metal so that it has oppositely facing major surfaces and edges extending between the major surfaces. The thickness of the terminals may vary depending upon the requirements in a particular situation.

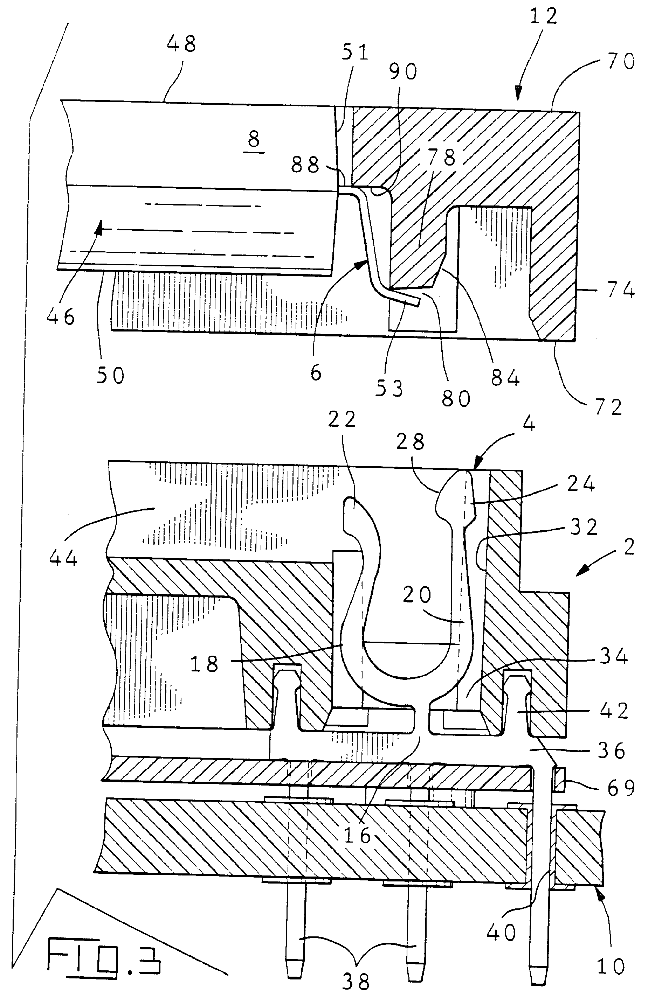

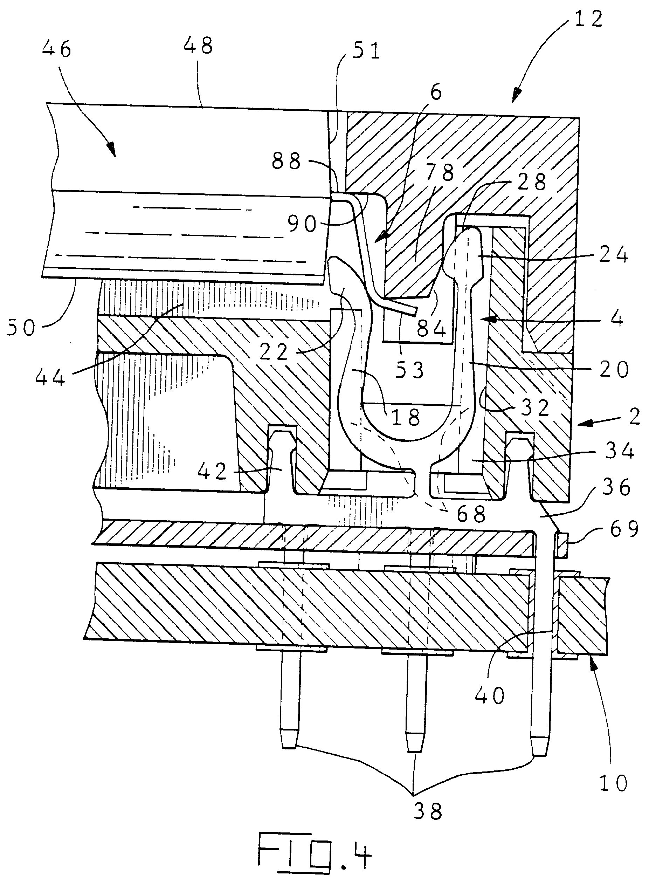

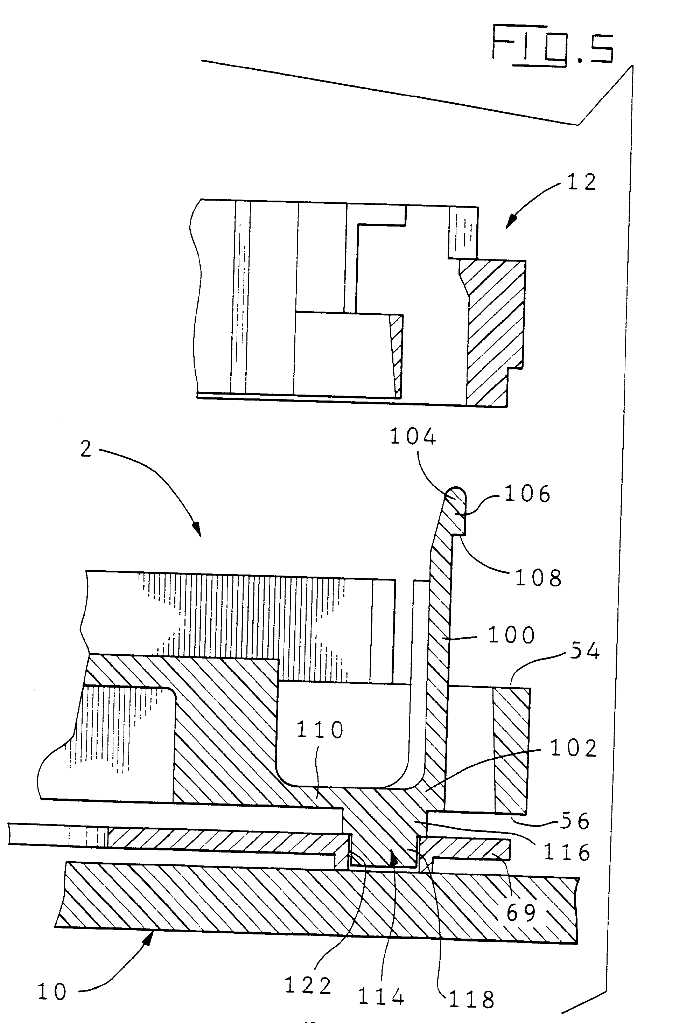

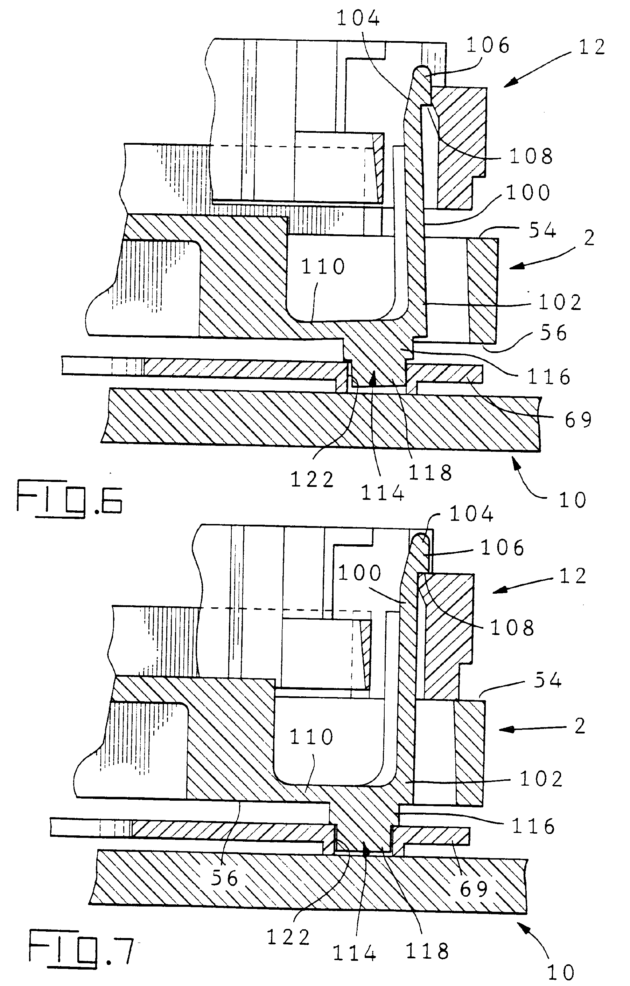

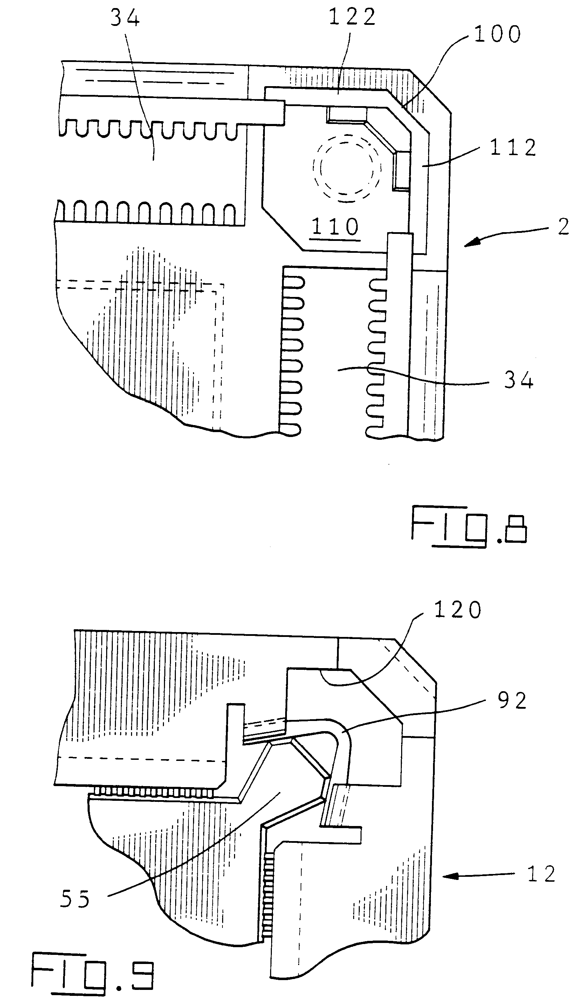

As is best shown in Figure 2, each terminal 4 comprises a resilient portion 14 having a flexible leg 16 extending from the resilient portion 14. The resilient portion 14 has a rounded, U-shaped configuration which is comprised of two resilient arms 18, 20. The first resilient arm 18 and the second resilient arm 20 have free ends 22, 24 which are spaced from each other but which are flexed relatively away from each other when the terminal 4 is stressed. As is best shown in Figures 3 and 4, resilient arm 20 is slightly longer than resilient arm 18.

The first resilient arm 18, of each terminal 4, is a contact arm and has a rightwardly facing, as viewed in Figure 3, contact surface 26 which cooperates with a respective lead 6 of the chip carrier 8. The second resilient arm 20 has a leftwardly facing lead-in surface 28 which helps to guide the cover 12 into place. It should be noted that neither of the free ends 22, 24 nor any portion of the resilient arms 18, 20 is in engagement with side surfaces 32 of a terminal receiving cavity 34 of socket 2 when the terminal 4 is in an unstressed or first position, as shown in Figure 3.

The U-shaped resilient portion 14 is pivotally mounted on leg 16. This allows the U-shaped resilient portion 14 to adjust for any dimensional variation or misalignment of the chip carrier 8 when the chip carrier is inserted into the socket 2. Dimensional variation or misalignment of the chip carrier 8 can cause the component lead positions to vary. Therefore, it is important that the U-shaped resilient portion 14 of each terminal 4 be free to pivot in order to compensate for this varied lead position. Consequently, as the terminals 4 of the socket 2 can adjust to the varied position of the leads 6 of the chip carrier 8, a positive electrical connection will be effected and maintained between each lead 6 and the respective terminal 4.

The leg 16 of each terminal 4 is integrally attached to a horizontal bar 36 from which a number of mounting portions 38 extend downward, as is shown in Figure 2. As is indicated in Figures 3 and 4, all but one of these mounting portions 38 are removed from any given terminal 4, thereby providing the required footprint to match the holes 40 in the substrate 10.

Each horizontal bar 36 has two support portions 42 which extend upward, in the same direction as leg 16. These support portions 42 are provided to cooperate with the housing of the socket 2 to provide support for the side walls 32 of the terminal receiving cavity 34.

When the terminals 4 are contained in the chip carrier socket 2 which in turn is mounted on a substrate 10 and a chip carrier 8 is placed in a chip carrier receiving recess 44 of the chip carrier socket 2, leads 6 and a portion of cover 12 extend between free ends 22, 24 of resilient arms 18, 20, as shown in Figure 4. The effect is to impose a force on the free ends 22, 24 of the resilient arms 18, 20 of the terminals 4. As a result of the imposition of this force, the resilient arms 18, 20 function as a spring system and the arms 18, 20 are flexed relatively away from each other. The stresses induced in the terminal 4 as a result of the force are largely concentrated in the arms 18, 20, and only a very minor portion of the force is transmitted through the leg 16 to the horizontal bar 36 and to the mounting portions 38. This is a highly desirable feature because a transfer of large forces to the mounting portions 38 would create stresses on the relatively weak solder joints. These stresses would result in the failure of the connection. Consequently, it is extremely important to prevent large stresses from being transferred to the mounting portions 38.

Turning now to Figure 3, the previously identified chip carrier 8 comprises, in the disclosed embodiment, a generally square chip carrier body 46 having upper and lower major surfaces 48, 50 and side surfaces 51. Side surfaces 51 extend between first major surface 48 and second major surface 50. Side surfaces 51 are slightly bowed, as is best shown in Figures 3 and 4. The leads 6 extend into the body 46 and are connected to the integrated circuit chip (not shown) therein. These leads 6 extend from side surfaces 51 of body 46 in a generally downward fashion, (modified gull wing configuration) as is shown in the Figure 4. The end portions 53 of leads 6 are bent such that the bottom surface of end portions 53 are approaching parallel to the lower major surface 50.

Chip carrier 8 has projections 55 extending from the corners thereof. Projections 55 extend from the first major surface 48 to the second major surface 50. The sides of projections 55 have the same bowed configuration as side surfaces 51.

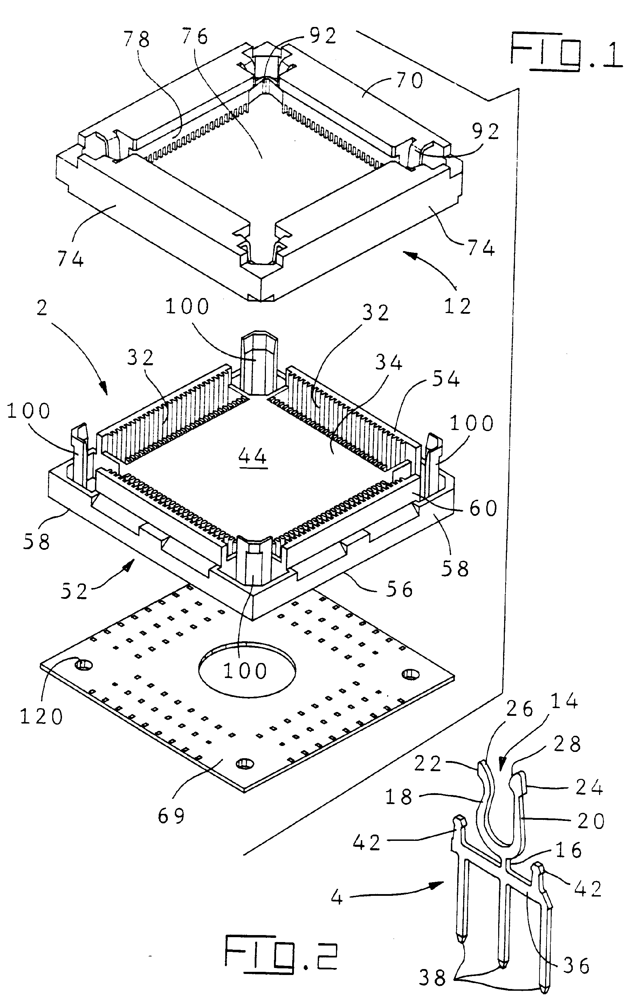

Referring to Figure 1, the chip carrier socket 2 comprises a socket body 52 having first and second major surfaces 54, 56 and side surfaces 58. The side surfaces 58 have an offset portion 60 proximate the first major surface 54, the offset portion 60 being provided to cooperate with the cover 12, as will be discussed. Chip carrier receiving recess 44 extends from the first major surface 54 toward the second major surface 56 and has recess side surfaces which correspond to respective side walls 32 of terminal receiving cavities 34 which extend to the second major surface 56 of socket 2.

Terminal-receiving cavities 34 are provided in the recess 44 and extend from the first major surface 54 to the second major surface 56. Each cavity 34 extends from proximate a corner of the recess 44 to proximate an adjacent corner of the recess 44. Cavities 34 have a general rectangular shape. Side-by-side slots 68 are provided on side walls 32. These slots 68 cooperate with the respective terminals 4 to align the terminals 4 in the proper position. As is shown in Figures 3 and 4, the terminals 4 are positioned in the slots 68, thereby preventing the terminals 4 from engaging each other, which in turn prevents the terminals 4 from shorting. It should be noted, that in order for chip carrier 8 to be inserted into chip carrier receiving recess 44, respective inner side walls 32 can not extend all the way to the first major surface 54.

As is best shown in Figures 3 and 4, terminals 4 do not contact side walls 32 when the terminals 4 are in an unstressed position. However, the spacing between side walls 32 is dimensioned such that the side walls 32 act as overstress means as the terminals 4 are stressed, i.e. sidewalls 32 prevent terminals 4 from bending far enough to take a permanent set. Consequently, side walls 32 of terminal receiving cavities 34 prevent the terminals 4 from taking a permanent set which would result in an ineffective electrical connection. In order to provide the side walls 32 with enough support to prevent the overstress of the terminals 4, the support members 42 which extend from the horizontal bars 36 of the terminals 4 are positioned in the housing 52 of the chip carrier socket 2. The positioning of terminals 4 allows the strength of the metal terminals 4 to reinforce the strength of the plastic housing 52, thereby providing the side walls 32 with the support necessary to prevent the overstress of the terminals 4.

Mounting portions 38 of terminals 4 extend from the second major surface 56 of chip carrier socket 2. A protective strip 69 is provided proximate the ends of mounting portions 38. Protective strip 69 cooperates with mounting portions 38 to maintain mounting portions 38 is proper position and to prevent the bending of mounting portions 38. As chip carrier socket 2 is inserted on the circuit board 10, protective strip 69 is moved along mounting portions 38 until protective strip 69 is proximate second major surface 56, thereby allowing mounting portions 38 to be inserted into circuit board 10.

Chip carrier socket 2 has latching arms 100 provided proximate the corners of socket body 52, as is shown in Figure 1. As is shown in Figures 5 through 7, latching arms 100 extend from second major surface 56 beyond first major surface 54. When viewed from above, as is shown in Figure 8, latching arms 100 have a general U-shaped configuration. Each latch arm 100 has a fixed end 102, which is integral with a portion of second major surface 56, and a free end 104. Provided proximate each free end 104 is a latch 106. A shoulder 108 of each latch 106 cooperates with the cover 12 to maintain the cover in position.

As is shown in Figures 5 through 7, fixed ends 102 of latch arms 100 are integral with a retention member 110 of second major surface 56. Retention members 110 have openings 112 provided on sides thereof (Figure 8). As shown in Figure 5, alignment projections 114 extend downward from retention members 110, away from first major surface 54. Alignment projections 114 are generally cylindrical in shape. First portions 116 of projections 114 have a larger diameter than second portions 118. The second portions 118 of projections 114 cooperate with openings 122 provided in protective strip 69. As is shown in the drawings, openings 122 have a larger diameter than second portions 118. This allows projections 114 to move relative to protective strip 69, as will be discussed.

Referring to Figure 1, cover 12 cooperates with the chip carrier 8, to prevent damage to the leads 6 of the chip carrier 8. Cover 12 is comprised of a first major surface 70, a second major surface 72, and side surfaces 74 extending therebetween. A chip carrier receiving recess 76 is provided in cover 12. The chip carrier receiving recess 76 extends from the first major surface 70 to the second major surface 72.

Extending in the recess 76 are chip carrier protective arms 78 which cooperate with the leads 6 of the chip carrier 8, as shown in Figures 3 and 4. Each lead 6 of chip carrier 8 is positioned in a slot 80 of arm 78. These slots 80 are provided to prevent leads 6 from electrically engaging one another, and also to provide protection to the leads 6, preventing the leads 6 from being damaged as the chip carrier 8 is inserted into the chip carrier socket 2.

As is best shown in Figures 3 and 4, protective arms 78 have surfaces 82 which cooperates with second resilient arms 20. Lead-in surfaces 84 are provided on arms 78 proximate the second major surface 72.

Chip carrier 8 is inserted into the cover 12 through the second major surface 72 thereof. Insertion of the chip carrier 8 continues until leading surfaces 88 of the leads 6 engage surfaces 90 of slots 80. This engagement prevents the chip carrier 8 from being further inserted in cover 12.

The chip carrier 8 is maintained in the cover 12 by the cooperation of the projections 55 of the corners of the chip carrier socket 2 and securing arms 92 of the cover 12, as is best shown in Figure 9. As is shown in Figure 9, resilient securing arms 92 engage respective surfaces of projections 55 of the chip carrier 8. These respective surfaces are angled. Consequently, as the chip carrier 8 is inserted into the cover 12, the resilient securing arms 92 will provide enough frictional engagement to prevent the chip carrier 8 from falling out of the recess 76 of the cover 12. Provided proximate securing arms 92 are openings 120. Openings 120 extend from first major surface 70 through second major surface 72.

As is shown in Figure 1, securing arms 92 are provided in the corners of cover 12. When viewed from above, as is shown in Figure 9, each securing arm 92 has a U-shape, the ends of which are integrally attached to the cover 12. This type of configuration allows the securing arms 92 to have the resilient characteristics required to insure that the chip carrier 8 is maintained in the cover 12. However, the configuration of the securing arms 92 also provides the strength characteristics required to insure that the securing arms 92 will be reliable over many insertions. As the ends of securing arms 92 are fixed, the insertion of the chip carrier 8 into the cover 12 causes the securing arms 92 of cover 12 to be engaged by the projections 55. This engagement causes securing arms 92 to deflect, to allow the projections 55 to be inserted therein. This deflection can cause failure of the securing arms, if the securing arms are not properly designed. With the ends of the securing arms 92 fixed in place, the securing arms have a twisting, pivoting, resilient motion, which allows the securing arms 92 to have the strength and resilient characteristics required to insure for proper operation over many cycles.

In operation, the chip carrier 8 is inserted into the cover 12 and maintained therein, as was described. The chip carrier and cover subassembly is then inserted into the chip carrier socket 2. This process is shown in Figures 3 and 4. Figure 3 shows the various parts just prior to insertion. As can be seen the terminals 4 of the chip carrier socket 2 are in an unstressed position. It should be noted that the downward force needed to insert the chip carrier-cover subassembly into the chip carrier socket 2 is applied to the cover. It should be noted that as this insertion occurs, leads 6 of chip carrier 8 are forced to conform to the shape of the slots 8 of the cover 12, as shown in Figure 4. This insures that leads 6 will be in engagement with cover 12, thereby insuring the the force applied to the leads 6 by the resilient arms 18 will be absorbed by the cover 12. Consequently, the fragile leads 6 of the chip carrier 8 are not damaged as insertion occurs, due to only minimal forces being directed at the leads.

As insertion occurs, leads 6 and protective arms 78 are inserted between the resilient arms 18, 20 of the terminals 4. However, as the width of the leads 6 and protective arms 78 is greater than the distance between the free ends 22, 24 of the resilient arms 18, 20, the resilient arms 18, 20 are forced apart. This force insures that as the insertion continues, the leads 6 will frictionally engage the contact surfaces 26 of the resilient arms 18. In other words, a contact wipe action will occur as insertion takes place.

As insertion continues, lead-in surfaces 84 of protective arms 78 will move past lead-in surfaces 28 of resilient arms 20, thereby allowing resilient arms 20 to move toward their unstressed position.

It is extremely important to note that although resilient arms 20 are allowed to move toward the unstressed position, the terminals 4 never reach the unstressed position when the protective arms 78 and leads 6 are inserted therein. Consequently, a force exists at all times between the leads 6 and the contact surfaces 26 of terminals 4, thereby insuring that a positive electrical connection is maintained.

Cover 12 is maintained in position on socket 2 by the cooperation of latch arms 100 and openings 120. The movement of latch arms 100 as cover 12 is inserted onto socket 2 is shown in Figures 5 through 7. As can be seen in Figure 6 the insertion of cover 12 onto socket 2 causes latch arms 100 to resiliently deform. This resilient deformation would be enough to cause failure of the latch arm in many of the prior art connectors. However, the configuration of retention members 110 with latch arms 100 prevents the failure of latch arms 100.

As latch members 100 are forced to resiliently deflect, retention members 110 are also caused to deflect. as latch arms 100 are integral with retention members 110. The resilient characteristics of retention members 110 are due to the positioning of openings 120 along the sides of the retention members. The openings 120 allow the retention members to resiliently deform as the latch members 100 are resiliently deformed, as illustrated in Figure 6. This is an important result because the possibility of failure in the latch arms 100 is reduced. In other words, the forces associated with the insertion of the cover onto the socket, are distributed between the latch arms 100 and the retention members 110. Therefore, the forces associated with the insertion of the cover onto the socket are not enough to prevent a failure of either the latch arms or the retention members.

Upon complete insertion, shoulders 108 of latches 106 are resiliently returned to an unstressed position, such that shoulders 108 cooperate with first major surface 70. Thus, cover 12 is maintained in position until latch arms 100 are released.

This configuration of latch arms 100 provides the advantage of increase reliability over many cycles. Therefore, the covers can be reused if required, thereby reducing costs. Another advantage is that no tools are required for insertion or removal of the cover or the chip carrier. This makes use of the socket in the field a much more practical solution.

The matter set forth in the foregoing description and accompanying drawings is offered by way of illustration only.

## Claims

1. A chip carrier socket (2) having terminals (4) provided therein and a first (56) and second (54) major surfaces of a socket body (52), the chip carrier socket providing the electrical connection required between a chip carrier (46) housed in a protective handler (12) and a printed circuit board, the chip carrier socket (2) being characterized in that:
portions of the first major surface (56) of the chip carrier socket are resilient retention areas (110), respective sides of the resilient retention areas (110) are integral with the first major surface (56), while the remaining sides of the resilient retention areas (110) are spaced from the first major surface,
the portions of the resilient retention areas (110) are movable from a first position, in which the portions are coplanar with the first major surface (56), to a second position, in which the portions are not coplanar with the first major surface (56),
resilient projections (100) are integral with and extend from the resilient retention areas (110), beyond the second major surface (54),
whereby as the resilient projections (100) have a force applied thereto, the resilient projections (100) are moved, causing the resilient retention areas (110) to move from the first position toward the second position, providing the strength required to prevent the failure of the resilient projections.

2. A chip carrier socket (2) as recited in claim 1 wherein the socket has a protective handler and wherein the protective handler (12) has resilient chip carrier retention means (92) provided proximate the corners thereof, the chip carrier retention means (92) providing the retention force required to maintain a chip carrier (46) in a chip carrier receiving opening (76) of the protective handler (12).

3. A chip carrier socket (2) as recited in claim 2 wherein the chip carrier retention means (92) has ends which are fixed to walls of the protective handler (12), and a midportion which is spaced from the walls of the protective handler (12), such that as the chip carrier (46) is inserted into the chip carrier receiving opening (76), the corners of the chip carrier (46) cooperate with the retention means (96) to cause the retention means to resiliently twist and pivot as the insertion occurs.

4. A chip carrier socket (2) as recited in claim 3 wherein the chip carrier retention means (96) has a generally U-shaped configuration.

5. A chip carrier socket (2) as recited in claim 1 wherein the resilient projections (100) are latch arms (100) which are provided proximate the corners of the socket (2).

6. A chip carrier socket (2) as recited in claim 5 wherein free ends of the latching arms (100) have shoulders (108) which cooperate with the projective handler (12) to maintain the chip protective handler (12) in position with respect to the chip carrier socket (2).

## Patentansprüche

1. Chipträgerfassung (2) mit darin vorgesehenen Anschlüssen (4) und mit einer ersten (56) und einer zweiten (54) Hauptfläche eines Fassungskörpers (52), wobei die Chipträgerfassung die elektrische Verbindung herstellt, die zwischen einem in einem Schutz-Handhabungsglied (12) untergebrachten Chipträger (46) und einer gedruckten Schaltungsplatte erforderlich ist,
dadurch gekennzeichnet,
daß Bereiche der ersten Hauptfläche (56) der Chipträgerfassung federnd nachgiebige Haltebereiche (110) sind und jeweilige Seiten der federnd nachgiebigen Haltebereiche (110) mit der ersten Hauptfläche (56) einstückig ausgebildet sind, während die übrigen Seiten der federnd nachgiebigen Haltebereiche (110) von der ersten Hauptfläche beabstandet sind,
daß die Bereiche der federnd nachgiebigen Haltebereiche (110) aus einer ersten Position, in der die Bereiche koplanar mit der ersten Hauptfläche (56) sind, in eine zweite Position bewegbar sind, in der die Bereiche nicht mit der ersten Hauptfläche (56) koplanar sind,
daß federnd nachgiebige Fortsätze (100) einstückig mit den federnd nachgiebigen Haltebereichen (110) ausgebildet sind und sich von diesen weg über die zweite Hauptfläche (54) hinauserstrecken,
wodurch beim Ausüben einer Kraft auf die federnd nachgiebigen Fortsätze (100) die federnd nachgiebigen Fortsätze (100) bewegt werden und dadurch eine Bewegung der federnd nachgiebigen Haltebereiche (110) aus der ersten Position in Richtung auf die zweite Position hervorgerufen wird, wodurch die zum Verhindern eines Versagens der federnd nachgiebigen Fortsätze erforderliche Kraft aufgebracht wird.

2. Chipträgerfassung (2) nach Anspruch 1,
dadurch gekennzeichnet, daß die Fassung ein Schutz-Handhabungsglied besitzt und das Schutz-Handhabungsglied (12) eine nahe bei seinen Ecken vorgesehene federnd nachgiebige Chipträger-Halteeinrichtung (92) aufweist, wobei die Chipträger-Halteeinrichtung (92) die zum Halten eines Chipträgers (46) in einer Chipträger-Aufnahmeöffnung (76) des Schutz-Handhabungsglieds (12) erforderliche Festhaltekraft aufbringt.

3. Chipträgerfassung (2) nach Anspruch 2,
dadurch gekennzeichnet, daß die Chipträger-Halteeinrichtung (92) an Wänden des Schutz-Handhabungsglieds (12) angebrachte Enden und einen von den Wänden des Schutz-Handhabungsglieds (12) beabstandeten Mittelbereich aufweist, so daß bei Einsetzen des Chipträgers (46) in die Chipträger-Aufnahmeöffnung (76) die Ecken des Chipträgers (46) mit der Halteeinrichtung (96) derart zusammenwirken, daß die Halteeinrichtung während des Einsetzvorgangs in federnd nachgiebiger Weise verdreht und gekippt wird.

4. Chipträgerfassung (2) nach Anspruch 3,
dadurch gekennzeichnet, daß die Chipträger-Halteeinrichtung (96) eine allgemein U-förmige Konfiguration besitzt.

5. Chipträgerfassung (2) nach Anspruch 1,
dadurch gekennzeichnet, daß es sich bei den federnd nachgiebigen Fortsätzen (100) um Verriegelungsarme (100) handelt, die nahe bei den Ecken der Fassung (2) vorgesehen sind.

6. Chipträgerfassung (2) nach Anspruch 5,
dadurch gekennzeichnet, daß freie Enden der Verriegelungsarme (100) Schultern (108) aufweisen, die mit dem Schutz-Handhabungsglied (12) derart zusammenwirken, daß das Schutz-Handhabungsglied (12) in bezug auf die Chipträgerfassung (2) in Position gehalten wird.

## Revendications

1. Douille (2) pour support intermédiaire de puce ayant des bornes (4) situées dans cette douille et des première (56) et seconde (54) surfaces principales d'un corps (52) de douille, la douille pour support intermédiaire de puce établissant la connexion électrique demandée entre un support intermédiaire (46) de puce logé dans un dispositif protecteur (12) de manipulation et une plaquette à circuit intégré, la douille (2) pour support intermédiaire de puce étant caractérisée en ce que :
des parties de la première surface principale (56) de la douille pour support intermédiaire de puce sont des zones élastiques (110) de retenue, des côtés respectifs des zones élastiques (110) de retenue sont réalisés d'une seule pièce avec la première surface principale (56), tandis que les côtés restants des zones élastiques (110) de retenue sont espacés de la première surface principale,
les parties des zones élastiques (110) de retenue sont mobiles d'une première position, dans laquelle les parties sont coplanaires avec la première surface principale (56), jusqu'à une seconde position dans laquelle les parties ne sont pas coplanaires avec la première surface principale (56),
des saillies élastiques (100) sont réalisées d'une seule pièce avec les zones élastiques (110) de retenue et s'étendent depuis ces zones, au-delà de la seconde surface principale (54),
de manière que, lorsqu'une force est appliquée aux saillies élastiques (100), celles-ci soient déplacées, amenant les zones élastiques (110) de retenue à se déplacer de la première position vers la seconde position, établissant la résistance demandée pour empêcher la détérioration des saillies élastiques.

2. Douille pour support intermédiaire (2) de puce selon la revendication 1, dans laquelle la douille comporte un dispositif protecteur de manipulation et dans laquelle le dispositif protecteur (12) de manipulation comporte des moyens élastiques (92) de retenue du support intermédiaire de puce prévus à proximité de ses angles, les moyens (92) de retenue du support intermédiaire de puce produisant la force de retenue demandée pour maintenir un support intermédiaire (46) de puce dans une ouverture (76) de réception de support intermédiaire de puce du dispositif protecteur (12) de manipulation.

3. Douille (2) pour support intermédiaire de puce selon la revendication 2, dans laquelle les moyens (92) de retenue du support intermédiaire de puce ont des extrémités qui sont fixées à des parois du dispositif protecteur (12) de manipulation, et une partie médiane qui est espacée des parois du dispositif protecteur (12) de manipulation, de manière que, lorsque le support intermédiaire (46) de puce est inséré dans l'ouverture (76) de réception du support intermédiaire de puce, les angles du support intermédiaire (46) de puce coopèrent avec les moyens (96) de retenue pour amener les moyens de retenue à effectuer élastiquement une torsion et un pivotement pendant que l'insertion a lieu.

4. Douille (2) pour support intermédiaire de puce selon la revendication 3, dans laquelle les moyens (96) de retenue du support intermédiaire de puce ont une configuration de forme globalement en U.

5. Douille (2) pour support intermédiaire de puce selon la revendication 1, dans laquelle les saillies élastiques (100) sont des bras de verrouillage (100) qui sont prévus à proximité des angles de la douille (2).

6. Douille (2) pour support intermédiaire de puce selon la revendication 5, dans laquelle les extrémités libres des bras (100) de verrouillage ont des épaulements (108) qui coopèrent avec le dispositif protecteur (12) de manipulation pour maintenir le dispositif protecteur (12) de manipulation de puce en position par rapport à la douille (2) pour support intermédiaire de puce.
